# EUROPÄISCHE PATENTSCHRIFT

(11) **EP 1 155 495 B1**
(45) Veröffentlichungstag und Bekanntmachung des Hinweises auf die Patenterteilung: **18.09.2002**
(21) Anmeldenummer: 00908955.8
(22) Anmeldetag: 01.02.2000
(51) Int. Cl.: H03D 7/14

(54) **VERFAHREN UND SCHALTUNG ZUR KOMPENSATIONSSTEUERUNG VON OFFSETSPANNUNGEN EINER IN EINEM SCHALTUNGSBAUSTEIN INTEGRIERTEN FUNKEMPFANGSSCHALTUNG**
METHOD AND CIRCUIT FOR CONTROLLING THE COMPENSATION OF OFFSET VOLTAGES OF A RADIO RECEIVER CIRCUIT WHICH IS INTEGRATED IN A CIRCUIT MODULE
PROCEDE ET CIRCUIT POUR COMMANDER LA COMPENSATION DE TENSIONS DE DECALAGE D'UN CIRCUIT DE RECEPTION RADIO INTEGRE DANS UN MODULE DE CIRCUIT

(30) Priorität: 03.02.1999 DE 19904376
(43) Veröffentlichungstag der Anmeldung: 21.11.2001
(73) Patentinhaber: Infineon Technologies AG, 81669 München (DE)
(72) Erfinder: SCHMAL, Josef, D-81547 München (DE); GOSSMANN, Timo, D-85579 Neubiberg (DE); LIPPERER, Georg, D-81735 München (DE); HERZINGER, Stefan, D-80686 München (DE)
(74) Vertreter: Epping Hermann & Fischer
(86) Internationale Anmeldenummer: DE0000264
(87) Internationale Veröffentlichungsnummer: WO00046914

(56) Entgegenhaltungen:
- EP-A- 0 594 894
- EP-A- 0 693 823
- DE-C- 19 743 272

## Beschreibung

Die Erfindung bezieht sich auf ein Verfahren gemäß dem Oberbegriff des Patentanspruchs 1.

Die Erfindung betrifft auch eine Schaltung zur Durchführung des Verfahrens.

Bei einem integrierten Funkempfänger- bzw. Funktransceiverbaustein wird im Empfangspfad ein an der Antenne in der Hochfrequenzlage anliegendes Empfangssignal (Nutzsignal) zuerst in eine Zwischenfrequenzlage (ZF) und anschließend mittels eines Demodulators (Mischer) in die Basisbandlage (BB) umgesetzt.

In diesem Empfangspfad können nun fertigungsbedingt Offsetspannungen auftreten. Diese Offsetspannungen werden durch die im Empfangspfad liegenden Verstärker ebenso wie das Nutzsignal verstärkt. Liegt am Eingang eines 16 dB-Verstärkers z.B. eine Offsetspannung von 20 mV, so ergibt sich am Ausgang dieses Verstärkers eine Offsetspannung von 126 mV. Diese hohe Offsetspannung führt zu einer Begrenzung des Nutzsignals, da durch die Offsetspannung der Aussteuerbereich dieses Verstärkers und aller im Empfangspfad nachfolgenden Verstärker verringert wird.

In allen hochfrequenten Schaltungsteilen (HF- und ZF-Lage) kann die Offsetspannung an geeigneten Stellen durch eine kapazitive Kopplung eliminiert werden. In der Basisbandlage, in der die Signalfrequenzen bei etwa 100 kHz liegen, ist eine kapazitive Kopplung allerdings nicht mehr möglich, da im integrierten Schaltungsbaustein für die kapazitive Kopplung sehr große Kapazitäten verwendet werden müßten. Derart große Kapazitäten benötigen jedoch beim Einschalten des Schaltungsbausteins sehr lange Aufladezeiten und beanspruchen eine erhebliche Chipfläche oder sind auf einem integrierten Schaltungsbaustein überhaupt nicht realisierbar.

Es ist aus der europäischen Patentanmeldung EP 0 693 823 bekannt, die im Basisband vorhandenen Offsetspannungen mit Hilfe einer Abtast- und Halteschaltung (Sample and Hold) zu kompensieren.

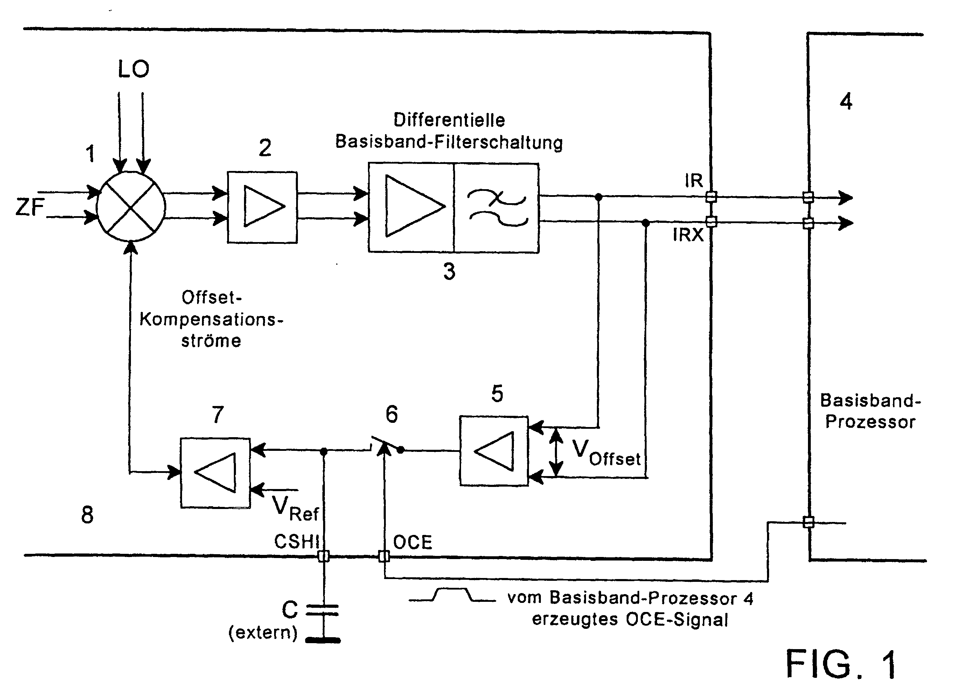

Wie FIG. 1 im einzelnen zeigt, wird dazu das differentielle Basisbandsignal, das über einen mit einer Lokaloszillatorfrequenz LO betriebenen Demodulator 1 aus dem ZF-Signal ZF gewonnen und nach einem Pufferverstärker 2 mittels einer Basisband-Filterschaltung 3 ausgefiltert wird, intern am Basisbandausgang IR, IRX, der mit einem nachfolgenden Basisband-Prozessor 4 verbunden ist, abgegriffen und einem Abtast-(Sample)-Operationsverstärker 5 zugeführt.

Dieser Operations-verstärker 5 lädt bzw. entlädt über einen gesteuerten Abtastschalter 6 der Abtast- und Halteschaltung je nach Polarität der Offsetspannung V_{Offset} über einen Ausgang CSHI einen extern angebrachten Kondensator C. Die Kondensatorspannung wird einem Differenzverstärker 7 zugeführt und dort mit einer Referenzspannung V_{Ref} verglichen. Am Ausgang des Differenzverstärkers 7 werden Kompensationsströme erzeugt, die der Offsetspannung V_{Offset} entgegenwirken. Der Offset-Kompensationsvorgang wird vor jedem Empfangszeitschlitz des im Zeitmultiplex (TDMA) betriebenen Funkempfängers durchgeführt. Dazu erfolgt die Steuerung des Abtastschalters 6 bei der bekannten Schaltung über ein bausteinexternes OCE(Offset Compensation Enable)-Steuersignal.

Das Steuersignal OCE benötigt einen eigenen Pin und muß vom in einem getrennten Chip realisierten Basisband-Prozessor 4 bereitgestellt werden. Im Basisband-Prozessor 4 ist zur Erzeugung dieses Steuersignals OCE ein zusätzlicher rungsaufwand erforderlich und es wird zusätzliche Rechnerleistung benötigt. Realisiert ist eine derartige Kompensation der Offsetspannung im Basisband beispielsweise im in FIG. 1 mit 8 bezeichneten Siemens-Receiver-Chip PMB 2405 für tragbare GSM-Mobilfunkgeräte.

In der DE 30 41 417 bzw, dem Familiendokument US-A-4377759 für ein PCM-Fernmeldesystem gezeigt. Die Schaltung kann als Bestandteil eines integrierten Schaltkreises ausgebildet werden. Dabei sollen diskrete äußere Bauelemente vermieden werden. Zur Offset-Kombensation sind ein bipolarer Spannungsgenerator sowie eine Integrationsschaltung mit umschaltbaren Kondensatoren vorgesehen.

Der Erfindung liegt die Aufgabe zugrunde, ein Verfahren und eine Schaltung zur Durchführung des Verfahrens anzugeben, die es möglich machen, daß zur Durchführung der Offsetspannungskompensation in Funkempfänger- oder -transceiverchips kein eigener Pin benötigt wird und ohne zusätzlichen Programmieraufwand sowie extra Rechnerleistung ausgekommen werden kann.

Diese Aufgabe wird bei einem gattungsgemäßen Verfahren durch die im kennzeichnenden Teil des Patentanspruchs 1 angegebenen Merkmale gelöst.

Steht also auf einem integrierten Receiver- bzw. Transceiverbaustein eine auch als Sequenzer bezeichnete Ablaufsteuerung zur Verfügung, so kann nach der Erfindung der Vorgang der Offsetspannungskompensation ohne ein externes OCE-Steuersignal, das vom Basisband-Prozessor bereitgestellt werden müßte, durchgeführt werden.

Ein vollautomatischer Ablauf der Offsetspannungskompensation und die Einsparung eines Steuer-Pins am integrierten, die Empfangsschaltung enthaltenden Schaltungsbaustein werden nach der Erfindung also dadurch erreicht, daß Steuer- und Programmiersignale, die ohnehin zur Einstellung der gewünschten Zu stände des integrierten Schaltungsbausteins benötigt werden, dazu benutzt werden, eine Ablaufsteuerung (Sequenzer) zu starten, die zusätzliche, zeitlich definierte Steuersignale auf dem integrierten Schaltungsbaustein (Chip) zur Verfügung stellt, ohne daß zusätzliche Rechenleistung von seiten des im Funkgerät enthaltenen Basisband-Prozessors erforderlich ist.

Zweckmäßige und vorteilhafte Weiterbildungen des Verfahrens nach der Erfindung sind in den Ansprüchen 2 bis 6 angegeben.

Eine die vorher angegebene Aufgabe lösende Schaltung zur Durchführung des Verfahrens nach Anspruch 1 ist in Patentanspruch 7 angegeben.

Das Verfahren nach einem der Ansprüche 1 bis 6 und die vorstehend angegebene Schaltung zur Durchführung dieses Verfahrens lassen sich besonders vorteilhaft in einem kleinen transportablen Mobilfunkgerät (Handy) verwenden, das in einem mit Zeitmultiplex arbeitenden Mobilfunksystem, beispielsweise in einem GSM- oder PCN/PCS-Mobilfunksystem, eingesetzt wird.

Die Erfindung wird im folgenden anhand von Zeichnungen erläutert. Es zeigen:
- FIG. 1: das bereits vorher beschriebene Blockschaltbild einer bekannten integrierten Schaltung mit einer Abtastund Halteschaltung zur Offsetspannungskompensation mit externem OCE-Steuersignal,
- FIG. 2: das Blockschaltbild einer entsprechend der Erfindung ausgebildeten integrierten Schaltung ebenfalls mit einer Abtast- und Halteschaltung, wobei jedoch die Offsetspannungskompensation intern durch ein in einem Sequenzer erzeugtes OCE-Steuersignal erfolgt,
- FIG. 3: einen Zeitablaufplan des in der Schaltung nach FIG. 2 vorgesehenen Sequenzers bei der Erzeugung des OCE-Steuersignals, und
- FIG. 4: ein Blockschaltbild eines integrierten Transceiver-Bausteins mit einer Schaltungsauslegung, bei der das Verfahren nach der Erfindung angewandt ist.

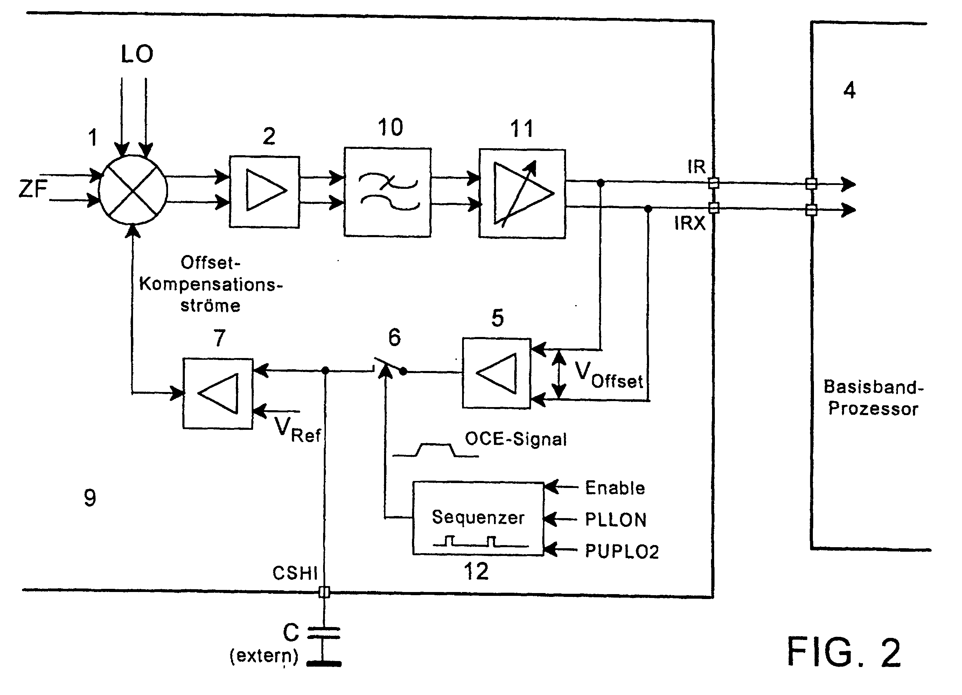

Die in FIG. 2 dargestellte Schaltung mit einem integrierten Receiver- bzw. Transceiverschaltungsbaustein 9 entspricht in weiten Teilen der bekannten Schaltung nach FIG. 1, weswegen in beiden Figuren für entsprechende Elemente auch übereinstimmende Bezugszeichen verwendet werden. Die im Basisband vorhandenen Offsetspannungen werden ebenfalls mit Hilfe einer Abtast- und Halteschaltung kompensiert.

Wie in FIG. 2 im einzelnen gezeigt ist, wird dazu das differentielle Basisbandsignal, das mit Hilfe eines mit einer Lokaloszillatorfrequenz LO gespeisten Demodulators 1 aus dem ZF-Signal ZF gewonnen und nach einem Pufferverstärker 2 mittels eines Tiefpaßfilters 10 ausgefiltert wird, intern nach Durchlaufen eines Basisband-Regelverstärkers 11 am Basisbandausgang IR, IRX, der mit einem nachfolgenden Basisband-Prozessor 4 verbunden ist, abgegriffen und einem Abtast(Sample)-Operationsverstärker 5 zugeführt.

Dieser Operationsverstärker 5 lädt bzw. entlädt je nach Polarität der Offsetspannung V_{Offset} über einen gesteuerten Abtastschalter 6 der Abtast- und Halteschaltung und über einen Ausgang CSHI einen extern angebrachten Kondensator C, der das Halteglied der Abtast- und Halteschaltung bildet.

Die Kondensatorspannung wird einem Differenzverstärker 7 zugeführt und dort mit einer Referenzspannung V_{Ref} verglichen. Am Ausgang des Differenzverstärkers 7 werden Kompensationsströme erzeugt, die der Offsetspannung V_{Offset} entgegenwirken. Auf dem integrierten Receiver- bzw. Transceiverschaltungsbaustein 9 steht eine Ablaufsteuerung in Form eines Sequenzers 12 zur Verfügung.

Der Vorgang der Offsetspannungskompensation läßt sich somit nach der Erfindung ohne ein externes Steuersignal, das bei der bekannten Schaltung vom Basisband-Prozessor 4 bereitgestellt werden muß, vor jedem TDMA-Empfangszeitschlitz durchführen.

Das benötigte OCE(Offset Compensation Enable)-Steuersignal für den Abtastschalter 6 wird intern im integrierten Receiver- bzw. Transceiverschaltungsbaustein 9 vom Sequenzer 12 erzeugt. Der das Steuersignal OCE abgebende Ausgang des auf dem integrierten Schaltungsbaustein 9 enthaltenen Sequenzers 12 ist dazu mit dem Steuereingang des ebenfalls auf diesem Schaltungsbaustein 9 enthaltenen Abtastschalters 6 verbunden.

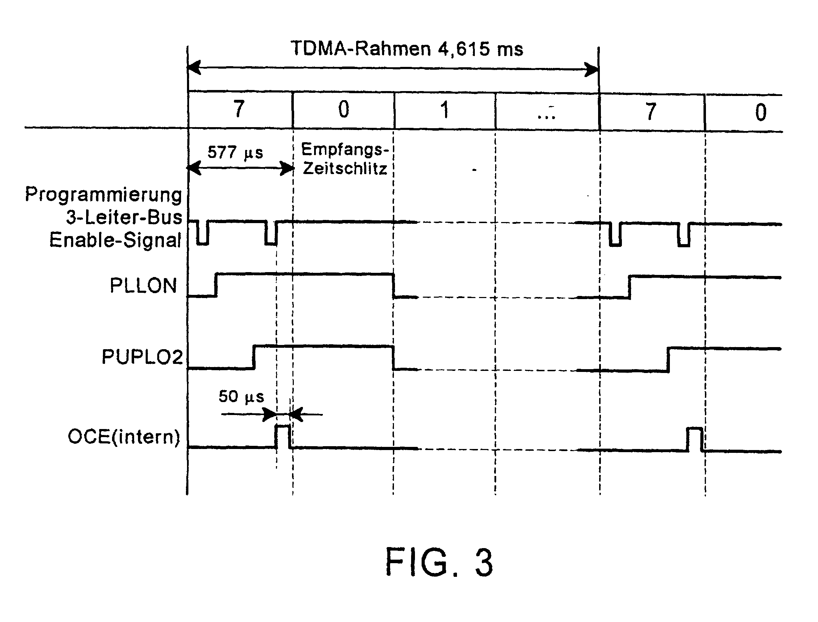

Der Sequenzer 12 wird noch vor dem aktiven Empfangszeitschlitz (RX-Slot) gestartet. Der zeitliche Ablaufplan des Sequenzers 12 ist in FIG. 3 im einzelnen dargestellt. Der Start des Sequenzers 12 erfolgt im Ausführungsbeispiel beim Beenden der Programmierung eines integrierten 3-Leiter-Busses, der an sich zur Ansteuerung anderer Funktionselemente und zur Erfüllung anderer Funktionen auf dem integrierten Schaltungsbaustein 9 dient.

Es werden zum Starten des Sequenzers 12 im Ausführungsbeispiel ein Enable-Steuersignal (3-Leiter-Bus) und zwei so bezeichnete Steuersignale PLLON und PUPLO2 herangezogen. Wie FIG. 3 zeigt, wird zum Start die ansteigende Flanke des Enable-Steuersignals ausgenutzt, wenn die beiden Steuersignale PLLON und PUPLO2 im HIGH-Zustand (= logisch 1) sind.

Der auf dem Schaltungsbaustein 9 integriert untergebrachte Sequenzer 12 entspricht einem ablaufenden Zähler, der zusammen mit einer Decodierlogik am Ausgang für bestimmte Signale, hier also für das Steuersignal OCE, eine zeitlich fest definierte Zustandsabfolge (Timing) ausgibt. Das impulsförmige Steuersignal OCE wird also intern auf dem Schaltungsbaustein 9 erzeugt.

Die Offsetspannungskompensation läuft damit ohne zusätzlichen, externen Steuer- und Rechenaufwand vom Basisband-Prozessor 4 ab. Gegenüber den bekannten Lösungen wird ein Steuer-Pin am Schaltungsbaustein 9 sowie Rechenleistung und Programmieraufwand im Basisband-Prozessor 4 eingespart.

Bei der in FIG. 2 dargestellten Realisierungsform für das Verfahren nach der Erfindung wird also der Sequenzer 12 von den drei impulsförmigen Steuersignalen Enable (3-Leiter-Bus), PLLON und PUPLO2 getriggert bzw. gestartet. Diese Signale sind schon auf dem integrierten Schaltungsbaustein 9 vorhanden und werden auch für andere Schalt- bzw. Einstellvorgänge benötigt.

Ist der Sequenzer 12 gestartet, dann legt er für eine Zeitdauer von etwa 50 µs das Steuersignal OCE auf HIGH-Pegel, was im FIG. 3 dargestellten, für einen TDMA-Rahmen (Dauer = 4,615 ms) des GSM-Mobilfunksystems geltenden Zeitablaufplan zu erkennen ist. Anschließend wird das Steuersignal OCE vom Sequenzer 12 wieder auf LOW-Pegel gelegt.

Nach dem Ablauf der Zählerfunktion im Sequenzer 12 stoppt der Sequenzer 12 und muß wieder von neuem von den drei triggernden Steuersignalen Enable, PLLON und PUPLO2 gestartet werden. Das bausteinintern erzeugte impulsförmige Steuersignal OCE steuert den Abtast(Sample)-Operationsverstärker 5 und somit den Offsetspannungskompensationsvorgang. Es sind keine extern erzeugten und somit eigens über einen besonderen Pin am Schaltungsbaustein 9 zuführbaren Steuersignale mehr nötig.

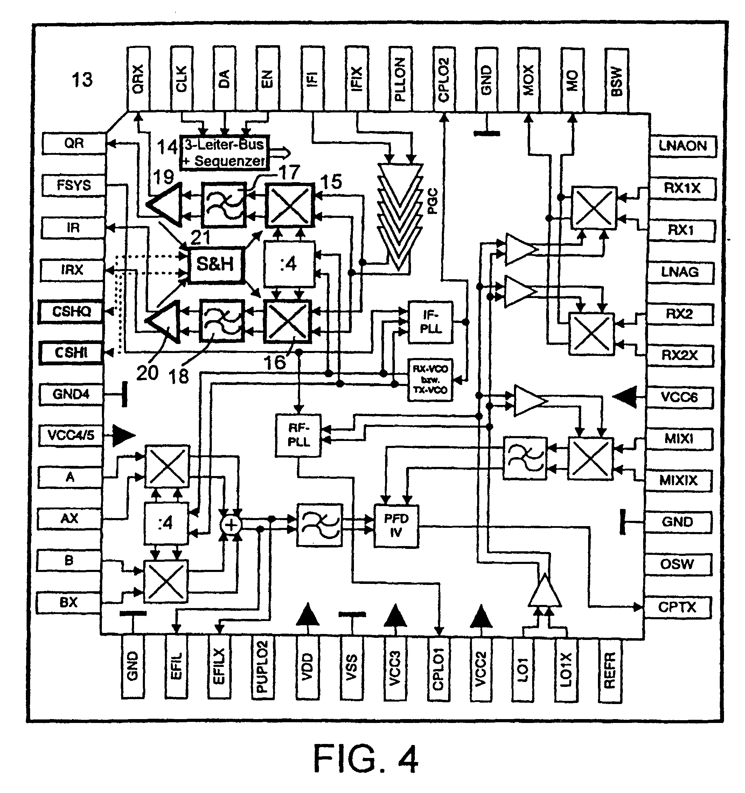

In FIG. 4 ist ein Blockschaltbild einer gesamten, in einem Schaltungsbaustein 13 integrierten Transceiverschaltung mit 3-Leiter-Bus und Sequenzer 14 dargestellt. Die von der Erfindung betroffenen Elemente im aus zwei differentiellen Signalpfaden (I- und Q-Pfad) bestehenden Empfangspfadteil wie die beiden Demodulatormischer 15 und 16, die beiden Tiefpaßfilter 17 und 18, die beiden differentiellen Basisband-Regelverstärker 19 und 20 sowie die Abtast- und Halteschaltung (Sample- and Hold-Schaltung; S&H) 21, die über die Pins CSHI und CSHQ mit externen, in der FIG. 4 nicht dargestellten Kondensatoren zusammenarbeitet, sind mit fett gezeichneten Umrandungslinien dargestellt.

Aus FIG. 4 ist ersichtlich, daß der integrierte Transceiverschaltungsbaustein 13 keinen eigenen Pin für das OCE-Steuersignal der Abtast- und Halteschaltung 21 aufweist, da dieses Steuersignal bausteinintern mit Hilfe des Sequenzers 14 erzeugt wird.

## Patentansprüche

1. Verfahren zur Kompensationssteuerung von Offsetspannungen im Basisband einer in einem Schaltungsbaustein integrierten, im Zeitmultiplexverfahren, nachfolgend TDMA bezeichnet, mit Empfangszeitschlitzen arbeitenden Funkempfangsschaltung unter Verwendung eines das Basisbandausgangssignal abgreifenden Abtast -Operationsverstärkers, der über einen von einem Offset-Compensation Enable-Steuersignal, nachfolgend OCE-Steuersignal bezeichnet, vor jedem Empfangszeitschlitz zur Durchführung eines Offset-Kompensationsvorgangs durchgeschalteten Abtastschalter einer Abtast- und Halteschaltung je nach Polarität der Offsetspannung einen extern angebrachten Kondensator lädt bzw. entlädt, dessen jeweils anliegender Spannungbaustein intern mittels eines Differenzverstärkers mit einer Referenzspannung verglichen wird und für die Erzeugung eines der Offsetspannung entgegenwirkenden Kompensationsstromes sorgt,
**dadurch gekennzeichnet,**
**daß** das dem Abtastschalter (6) zuzuführende OCE-Steuersignal (OCE) von einem auf dem integrierten Schaltungsbaustein (9) ohnehin vorhandenen, für die Ablaufsteuerung vorgesehenen Sequenzer (12) bausteinintern erzeugt wird, der stets noch vor Beginn des aktiven TDMA-Empfangszeitschlitzes gestartet wird und für bestimmte Signale eine zeitlich fest definierte Zustandsabfolge zur Ablaufsteuerung auf dem Schaltungsbaustein ausgibt, daß der Sequenzer (12) einen ablaufenden Zähler enthält, der zusammen mit einer Decodierlogik am Ausgang des Zählers für die bestimmten Signale die zeitlich fest definierte Zustandsfolge ausgibt, und daß der Sequenzer (12) in Abhängigkeit von drei impulsförmigen Steuersignalen gestartet wird, die über einen 3-Leiter-Bus in den Schaltungsbaustein eingegeben werden und den Sequenzer (12) starten, wenn eines der Steuersignale (Enable) eine Flanke aufweist, während die beiden anderen der Steuersignale (PLLON, PUPLO2) sich in einem HIGH-Zustand befinden.

2. Verfahren nach Anspruch 1,
**dadurch gekennzeichnet,**
**daß** der Sequenzer (12) beim Beenden der Programmierung des Schaltungsbausteins durch die drei Steuersignale gestartet wird und daß eines der Steuersignale (Enable) ein Enable-Steuersignal des 3-Leiter-Busses ist.

3. Verfahren nach den Ansprüchen 1 oder 2,
**dadurch gekennzeichnet,**
**daß** der Sequenzer (12) stets von der Endflanke, z.B. einer ansteigenden Flanke, des impulsförmigen Enable-Steuersignals gestartet wird, wenn sich die beiden anderen impulsförmigen Steuersignale (PLLON, PUPLO2) in einem festgelegten logischen Zustand, z.B. beide im logischen Zustand High (= logisch 1), befinden.

4. Verfahren nach einem der vorhergehenden Ansprüche,
**dadurch gekennzeichnet,**
**daß** der Sequenzer (12) nach seinem Start das OCE-Steuersignal für eine festgelegte Zeitdauer als Steuersignal an den Abtastschalter zu dessen Durchschaltung legt und danach das OCE-Steuersignal wieder abschaltet.

5. Verfahren nach Anspruch 4,
**dadurch gekennzeichnet,**
**daß** die festgelegte Zeitdauer des wirksamen OCE-Steuersignals etwa 50 µs beträgt.

6. Verfahren nach einem der Ansprüche 2 bis 5,
**dadurch gekennzeichnet,**
**daß** nach dem Ablauf des Zählers der Sequenzer (12) stoppt und danach von neuem von den drei Steuersignalen gestartet wird.

7. Schaltung mit Mitteln zur Durchführung des Verfahrens nach einem der Ansprüche 1 bis 6,
**dadurch gekennzeichnet,**
**daß** der das OCE-Steuersignal abgebende Ausgang des auf dem integrierten Schaltungsbaustein (9) enthaltenen Sequenzers (12) mit dem Steuereingang des ebenfalls auf diesem Schaltungsbaustein enthaltenen Abtastschalters (6) der Abtast- und Halteschaltung verbunden ist, daß der Schaltungsbaustein eine Einrichtung für einen 3-Leiter-Bus enthält, daß der 3-Leiter-Bus drei impulsförmige Steuersignale empfängt und daß der Sequenzer (12) derart ausgebildet ist, daß er gestartet wird, wenn eines der Steuersignale (Enable) eine Flanke aufweist, während die beiden anderen der Steuersignale (PLLON, PUPLO2) sich in einem HIGH-Zustand befinden.

8. Verwendung des Verfahrens nach einem der Ansprüche 1 bis 6 und der Schaltung nach Anspruch 7 in einem transportablen Mobilfunkgerät, das in einem mit Zeitmultiplex arbeitenden Mobilfunksystem, beispielsweise in einem GSM- oder PCN/PCS-Mobilfunksystem, eingesetzt wird.

## Claims

1. Method for compensation control of offset voltages in baseband in a radio receiving circuit which is integrated in a circuit module and operates using the time-division multiple access method, hereinafter referred to as TDMA, with reception timeslots using a sampling operational amplifier which taps off the baseband output signal and charges and discharges an externally fitted capacitor depending on the polarity of the offset voltage via a sampling switch in a sample and hold circuit, which sampling switch is switched on by an offset compensation enable control signal, hereinafter referred to as OCE control signal, before each reception timeslot in order to carry out an offset compensation process, in which case the voltage module [sic] in each case applied to said capacitor is compared internally with a reference voltage by means of a differential amplifier and ensures the production of a compensation current which counteracts the offset voltage,
**characterized**
**in that** the OCE control signal (OCE) which is to be supplied to the sampling switch (6) is produced within the module by a sequencer (12) which is provided any way on the integrated circuit module (9), is intended for sequence control, is always started even before the start of the active TDMA reception timeslot and, for specific signals, emits a state sequence, which is defined such that it is fixed in time, for the sequence control on the circuit module, in that the sequencer (12) contains a running-down counter which, together with decoding logic at the output of the counter, emits the state sequence, which is defined such that it is fixed in time, for the specific signals, and in that the sequencer (12) is started as a function of three pulsed control signals which are input to the circuit module via a three-conductor bus and start the sequencer (12) when one of the control signals (enable) has a flank, while the two other control signals (PLLON, PUPLO2) are in a HIGH state.

2. Method according to Claim 1,
**characterized**
**in that** the sequencer (12) is started by the three control signals when the programming of the circuit module ends, and in that one of the control signals (enable) is an enable control signal on the three-conductor bus.

3. Method according to Claims 1 or 2,
**characterized**
**in that** the sequencer (12) is always started by the end flank, for example a rising flank, of the pulsed enable control signal when the two other pulsed control signals (PLLON, PUPLO2) are in a defined logic state, for example both are in the high (= logic 1) logic state.

4. Method according to one of the preceding claims,
**characterized**
**in that**, once it has been started, the sequencer (12) applies the OCE control signal to the sampling switch as a control signal to switch it on for a fixed time period, and then switches the OCE control signal off once again.

5. Method according to Claim 4,
**characterized**
**in that** the defined time period of the effective OCE control signal is approximately 50 µs.

6. Method according to one of Claims 2 to 5,
**characterized**
**in that**, once the counter has run down, the sequencer (12) stops and is then started from new by the three control signals.

7. Circuit with means for carrying out the method according to one of Claims 1 to 6,
**characterized**
**in that** that output which emits the OCE control signal from the sequencer (12) which is contained on the integrated circuit module (9) is connected to the control input of the sampling switch (6) of the sample and hold circuit, which sampling switch (6) is likewise contained on this circuit module, in that the circuit module contains a device for a three-conductor bus, in that the three-conductor bus receives three pulsed control signals, and in that the sequencer (12) is configured in such a manner that it is started when one of the control signals (enable) has a flank, while the other two control signals (PILLON, PUPLO2) are in a HIGH state.

8. Use of the method according to one of Claims 1 to 6, and of the circuit according to Claim 7 in a transportable mobile radio, which is used in a mobile radio system which operates using time division multiple access, for example in a GSM or PCN/PCS mobile radio system.

## Revendications

1. Procédé pour commander la compensation de tensions de décalage dans la bande de base d'un circuit de réception radio intégré dans un module de circuit, fonctionnant dans le procédé de multiplexage dans le temps, désigné dans ce qui suit par TDMA, par des fenêtres temporelles de réception, en utilisant un amplificateur opérationnel d'échantillonnage qui prélève le signal de sortie de bande de base et qui, par l'intermédiaire d'un commutateur d'échantillonnage d'un circuit d'échantillonnage et de maintien interconnecté par un signal de commande Offset-Compensation Enable, désigné dans ce qui suit comme signal de commande OCE, avant chaque fenêtre temporelle de réception pour l'exécution d'une opération de compensation de décalage, charge ou décharge suivant la polarité de la tension de décalage un condensateur monté de manière externe dont le module de tension qui s'y applique respectivement est comparé de manière interne à une tension de référence au moyen d'un amplificateur différentiel et assure la production d'un courant de compensation contrecarrant la tension de décalage,
**caractérisé**
**en ce que** ce que le signal OCE de commande OCE à envoyer au commutateur (6) d'échantillonnage est produit de manière interne au module par un séquenceur (12) présent de toute façon sur le module (9) de circuit intégré, prévu pour la commande de déroulement, qui est mis en route toujours dès avant le début de la fenêtre temporelle de réception TDMA active et qui émet pour des signaux déterminés une séquence d'état définie de manière fixe dans le temps pour la commande de déroulernent sur le module de circuit, en ce que le séquenceur (12) contient un compteur qui tourne et qui émet conjointement avec une logique de décodage, à la sortie du compteur, pour les signaux déterminés, la séquence d'état définie de manière fixe dans le temps, et en ce que le séquenceur (12) est mis en route en fonction de trois signaux de commande en forme d'impulsions qui sont entrés dans le module de circuit par l'intermédiaire d'un bus à trois conducteurs et qui mettent en route le séquenceur (12) si l'un des signaux de commande (Enable) comporte un front, tandis que les deux autres (PLLON, PUPLO2) des signaux de commande se trouvent à un état HIGH.

2. Procédé suivant la revendication 1, **caractérisé en ce que** le séquenceur (12) est mis en route lors de l'achèvement de la programmation du module de circuit par les trois signaux de commande et **en ce que** l'un des signaux de commande (Enable) est un signal de commande du bus à trois conducteurs.

3. Procédé suivant les revendications 1 ou 2, **caractérisé en ce que** le séquenceur (12) est mis en route toujours par le front de fin, par exemple un front montant, du signal de commande Enable en forme d'impulsions si les deux autres signaux (PLLON, PUPLO2) de commande en forme d'impulsions se trouvent en un état logique fixé, par exemple tous deux à l'état logique High (= 1 logique).

4. Procédé suivant l'une des revendications précédentes, **caractérisé en ce que** le séquenceur (12) met, après sa mise en route, le signal de commande OCE, pour une durée fixée, comme signal de commande sur le commutateur d'échantillonnage pour son interconnexion et déconnecte ensuite à nouveau le signal de commande OCE.

5. Procédé suivant la revendication 4, **caractérisé en ce que** la durée fixée du signal de commande OCE actif est égale à environ 50 µs.

6. Procédé suivant l'une des revendications 2 à 5, **caractérisé en ce que** le séquenceur (12) s'arrête après que le compteur a cessé et est mis en route ensuite depuis le début par les trois signaux de commande.

7. Circuit comportant des moyens pour la mise en oeuvre du procédé suivant l'une des revendications 1 à 6, **caractérisé en ce que** la sortie, fournissant le signal de commande OCE, du séquenceur (12) contenu dans le module (9) de circuit intégré, est reliée à l'entrée de commande du commutateur (6) d'échantillonnage, également contenu dans ce module de circuit, du circuit d'échantillonnage et de maintien, **en ce que** le module de circuit contient un dispositif pour un bus à trois conducteurs, **en ce que** le bus à trois conducteurs reçoit des signaux de commande en forme d'impulsions et **en ce que** le séquenceur (12) est réalisé de telle manière qu'il est mis en route si l'un des signaux de commande (Enable) comporte un front, tandis que les deux autres (PLLON, PUPLO2) des signaux de commande se trouvent à un état HIGH.

8. Utilisation du procédé suivant l'une des revendications 1 à 6 et du circuit suivant la revendication 7 dans un appareil de radiocommunication mobile transportable qui est utilisé dans un système de radiocommunication mobile travaillant par multiplexage dans le temps, par exemple dans un système de radiocommunication mobile GSM ou PCN/PCS.
